# EUROPEAN PATENT APPLICATION

(11) **EP 4 711 210 A1**
(43) Date of publication of application: **18.03.2026**
(21) Application number: 25201145.7
(22) Date of filing: 09.09.2025
(51) Int. Cl.: B60R 16/02, B60R 16/023

(54) **MODULAR HARNESS SYSTEM**

(30) Priority: 13.09.2024 SE 2450909
(71) Applicant: Volvo Penta Corporation, 405 08 Göteborg (SE)
(72) Inventor: SJÖSTEDT, Nina, 417 08 GÖTEBORG (SE); KERSTEN, Anton, 433432 PARTILLE (SE); DWARAKANATH, Shreyas, 412 75 GÖTEBORG (SE); ASPLING, Fredrik, 438 39 LANDVETTER (SE); JÄDERSTRÖM SJÖDAHL, Björn, 443 70 GRÅBO (SE); HALLGREN, Jonas, 417 09 GÖTEBORG (SE); BÄCKMAN, Vincent, 415 23 GÖTEBORG (SE); UDD, Rickard, 471 31 SKÄRHAMN (SE)
(74) Representative: Ström & Gulliksson AB

(57) **Abstract**

A modular harness system (100) for connecting a master electronic control module (10) to a plurality of electrical system components (12), the harness system (100) comprising: a main backbone section (5) connectable to the master electronic control module (10); an electrical and communication interface (50) connected to the main backbone section (5); a plurality of modular harness sections (20), each harness section (20) connecting to a respective electrical system component (12); an extension section (30) comprising an extension wire (32); and a connector section (40) configured to interconnect a preceding modular harness section (20-1) in series with a subsequent modular harness section (20-2), from among the plurality of modular harness sections (20), to relay data and/or supply electrical power via the extension wire (32).

## Description

### TECHNICAL FIELD

The disclosure relates generally to wiring harnesses for electrical components. In particular aspects, the disclosure relates to a modular harness system. The disclosure can be applied to heavy-duty vehicles, such as trucks, buses, and construction equipment, among other vehicle types. The disclosure can also be applied to other areas of application, such as marine vessels, industrial applications, stationary applications, among other areas of application. Although the disclosure may be described with respect to a particular vehicle, the disclosure is not restricted to any particular vehicle.

### BACKGROUND

In modern electronic systems, harness systems are used for connecting various electrical components and ensuring reliable transmission of data and power across applications such as automotive, aerospace, and industrial automation. These systems typically comprise multiple wiring sections, connectors, and other components that facilitate interconnection to a central control module.

To address the limitations of rigid, monolithic harnesses, modular systems have been developed. These systems often employ a parallel bus architecture where a central wiring bus runs through a vehicle or machine, and various electrical components can be connected to it at different points. While this improves flexibility over monolithic designs, these parallel architectures face significant technical limitations, particularly when the harness must span long distances. A particular limitation arises with high-speed communication protocols, such as the Controller Area Network (CAN bus), which are sensitive to the physical layout of the wiring. In conventional parallel bus systems, creating long branches or stubs from the main bus to connect distant components introduces signal reflection and impedance mismatches. This signal degradation can corrupt data transmission, rendering the communication unreliable and severely limiting the maximum functional length and scalability of the entire harness system. Furthermore, this technical limitation imposes an architectural constraint: every electrical component must be located in close proximity to the path of the main bus to keep the connecting stubs short. This severely restricts the design freedom for component placement, complicating the overall layout of the vehicle or machine and preventing components from being positioned in their most optimal locations.

It is in view of the above limitations of the prior art and others that the present inventor is herein suggesting one or more improvements to the prior art.

### SUMMARY

The present inventors have recognized the aforementioned limitations inherent in conventional parallel bus harness architectures. Specifically, they identified that the requirement for long branch connections, or stubs, to reach distant components is the primary cause of signal degradation on high-speed communication buses like CAN, creating a fundamental barrier to creating longer, more complex, yet reliable modular systems.

In addressing this challenge, the inventors departed from the conventional approach of trying to condition the signals on these problematic long stubs. They realized that the core problem was not the overall length of the main bus itself, but the length of the individual parallel branches tapping into it. This realization led to the development of a novel topology based on a sequential physical interconnection of the harness sections.

In this new architecture, the modular harness sections are not connected in parallel to a central trunk line. Instead, they are interconnected sequentially, one after the other, forming a continuous chain. By doing so, the main communication bus is effectively extended through each section, while the breakout connection from the bus to the actual electrical component at each node remains inherently short. This physical arrangement supports various electrical circuit types; for example, a high-voltage interlock loop can be wired in an electrical series, while a CAN bus follows the serial path as an electrically parallel bus. This topology preserves signal integrity regardless of the total system length, enabling highly scalable and reliable modular harnesses that were previously not feasible. In addition, it provides enhanced flexibility in the placement of electrical components. In conventional parallel systems, the need to keep branch stubs short forces designers to locate components in close proximity to the path of the main bus. The disclosed serial architecture eliminates this constraint. The main harness can be extended and routed as needed to reach components wherever they are preferably located within a vehicle or machine, be it for functional, thermal, or spatial efficiency. This ability to place components virtually anywhere and always be able to reach them with the modular harness system, without fear of signal degradation or power loss, provides a degree of design freedom that is unachievable with prior art architectures.

In a first aspect of the disclosure there is accordingly provided a modular harness system for connecting a master electronic control module to a plurality of electrical system components, the harness system comprising: a main backbone section connectable to the master electronic control module; an electrical and communication interface connected to the main backbone section; a plurality of modular harness sections, each harness section connecting to a respective electrical system component; an extension section comprising an extension wire; and a connector section configured to interconnect a preceding modular harness section in series with a subsequent modular harness section, from among the plurality of modular harness sections, to relay data and/or supply electrical power via the extension wire.

The first aspect of the disclosure may seek to address the limitations of conventional wiring harnesses, which are difficult to scale and suffer from signal integrity degradation in long-distance communication buses. A technical benefit may include maintaining communication signal integrity over extended distances in a scalable system, an advantage not achievable with prior art parallel-branched architectures due to, e.g., signal reflection from long connection stubs.

Optionally in some examples, including in at least one preferred example, each modular harness section comprises an input connector and an output connector, and wherein the output connector of the preceding modular harness section is connected to the input connector of the subsequent modular harness section via the extension wire. A technical benefit may include providing a clear and unambiguous structural definition for the serial connection, enhancing system integrity and ease of assembly.

Optionally in some examples, including in at least one preferred example, the serial connection is a daisy-chain connection. A technical benefit may include simplifying system design by employing a recognized and standardized connection topology.

Optionally in some examples, including in at least one preferred example, the system further comprises a terminating plug configured to be connected to a final connector section in the series, the terminating plug comprising one or more of a terminating resistor for a communication bus and a high-voltage interlock loop, HVIL. A technical benefit may include preventing signal reflection and ensuring the stability and safety of the communication bus and high-voltage circuits.

Optionally in some examples, including in at least one preferred example, the serial interconnection of the modular harness sections forms a main communication bus of the modular harness system, the length of the main communication bus being controllable based on a predetermined length. A technical benefit may include enabling the creation of long and scalable harness systems while maintaining signal integrity, which is not possible with parallel bus architectures.

Optionally in some examples, including in at least one preferred example, the electrical and communication interface comprises one or more of an overcurrent fuse, a signal line filter, a galvanic isolator, a CAN/LIN bus, and a surge protection suppressor. A technical benefit may include enhancing system safety, reliability, and regulatory compliance by integrating protective components directly into the harness interface.

Optionally in some examples, including in at least one preferred example, the electrical and communication interface is configured to automatically adjust a parameter of the harness system. A technical benefit may include enabling active, real-time system management to ensure continuous compliance and optimal performance without manual intervention.

Optionally in some examples, including in at least one preferred example, the parameter comprises at least one of a power distribution setting, a communication protocol setting, and a sensor calibration value. A technical benefit may include providing specific and versatile means of control over the system's electrical and data-handling characteristics.

Optionally in some examples, including in at least one preferred example, the electrical and communication interface is configured to receive firmware updates to address new or revised regulatory requirements. A technical benefit may include future-proofing the harness system, allowing it to adapt to changing standards without requiring hardware replacement.

Optionally in some examples, including in at least one preferred example, the electrical and communication interface comprises an integrated microcontroller. A technical benefit may include providing the necessary processing capability to enable the intelligent and automatic adjustment features of the interface.

Optionally in some examples, including in at least one preferred example, each connector section comprises a locking mechanism to secure the modular harness sections in the serial connection. A technical benefit may include increasing the physical robustness and reliability of the harness connections, preventing accidental disconnection due to vibration or stress.

Optionally in some examples, including in at least one preferred example, the main backbone section comprises a protective casing. A technical benefit may include protecting the primary wiring path from physical damage, abrasion, and environmental factors.

Optionally in some examples, including in at least one preferred example, at least one connector section includes an indicator light to signal a connection status. A technical benefit may include simplifying system installation and troubleshooting by providing immediate visual feedback on the integrity of the connections.

In a second aspect of the disclosure there is provided a vehicle comprising the modular harness system of the first aspect.

The second aspect of the disclosure may seek to address the limitations of conventional wiring harnesses, which are difficult to scale and suffer from signal integrity degradation in long-distance communication buses. A technical benefit may include maintaining communication signal integrity over extended distances in a scalable system, an advantage not achievable with prior art parallel-branched architectures due to, e.g., signal reflection from long connection stubs.

In a third aspect of the disclosure there is provided a method for arranging a modular harness system, comprising: connecting a master electronic control module to a main backbone section; connecting an electrical and communication interface to the main backbone section; connecting a plurality of electrical system components to a respective modular harness section; and interconnecting, via a connector section and an extension wire, a preceding modular harness section in series with a subsequent modular harness section, from among the plurality of modular harness sections, to relay data and/or supply electrical power.

The third aspect of the disclosure may seek to address the limitations of conventional wiring harnesses, which are difficult to scale and suffer from signal integrity degradation in long-distance communication buses. A technical benefit may include maintaining communication signal integrity over extended distances in a scalable system, an advantage not achievable with prior art parallel-branched architectures due to, e.g., signal reflection from long connection stubs.

The disclosed aspects, examples (including any preferred examples), and/or accompanying claims may be suitably combined with each other as would be apparent to anyone of ordinary skill in the art. Additional features and advantages are disclosed in the following description, claims, and drawings, and in part will be readily apparent therefrom to those skilled in the art or recognized by practicing the disclosure as described herein.

### BRIEF DESCRIPTION OF THE DRAWINGS

Examples are described in more detail below with reference to the appended drawings.
**FIG. 1** is an system diagram of a heavy duty vehicle, according to an example.
**FIG. 2** is an exemplary illustration of a modular harness system, according to an example.
**FIG. 3** is an exemplary illustration of a modular harness system including a final connector section, according to an example.
**FIG. 4** is an exemplary method for arranging a modular harness system, according to an example.

### DETAILED DESCRIPTION

The detailed description set forth below provides information and examples of the disclosed technology with sufficient detail to enable those skilled in the art to practice the disclosure.

The present disclosure provides a modular harness system that may address the challenges of the prior art through a novel topology based on a sequential, physical interconnection, wherein modular harness sections are interconnected sequentially to relay data and power from one section to the next. This sequential architecture is different from conventional parallel topologies of the prior art, where each modular harness section connects independently to a central bus or trunk line. In such prior parallel systems, each connection forms a separate branch, which can lead to signal integrity issues when the branches become long. This physical arrangement, however, is capable of supporting various electrical circuit types, such as an electrically parallel communication bus. Therefore, in the sequential physical topology presented herein it is possible to support different electrical circuit configurations; for example, while the harness sections are connected in a physical series, the wiring within can form an electrically parallel communication bus.

A technical effect that may occur from this arrangement is the maintenance of high signal integrity along a main communication bus of considerable length, as the breakout connections to individual components can be kept very short. Potential improvements or advantages of this technical effect may include enhanced system scalability, greater reliability for high-speed data communication, and increased design freedom in the placement of electrical components throughout a large-scale application.

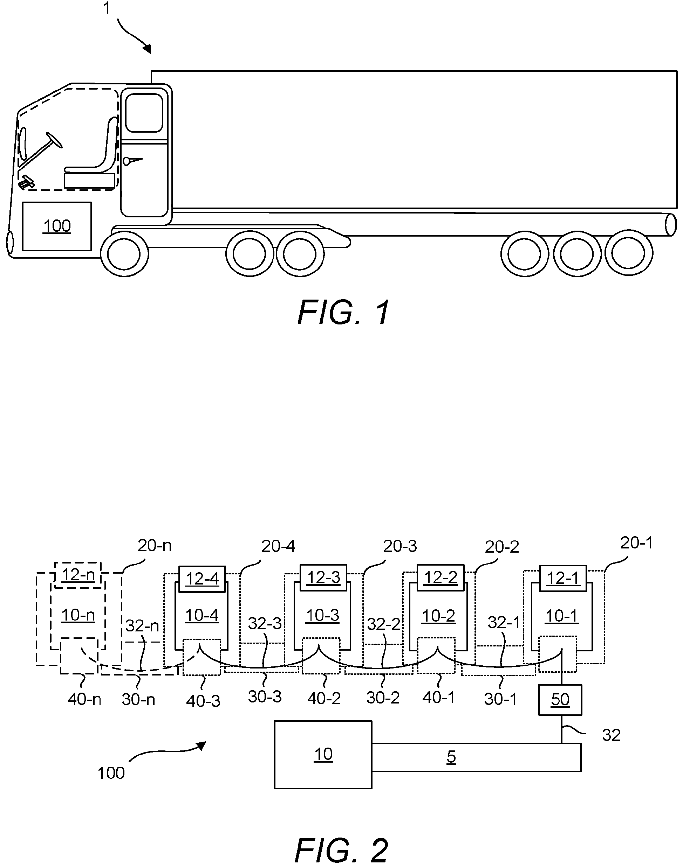

**FIG. 1** illustrates an exemplary application area for a modular harness system **100.** The disclosed system has been developed for applications such as a battery energy storage system, BESS. The figure shows a heavy-duty vehicle **1,** which is an example of an application utilizing such a BESS. Such a system, particularly when installed in the vehicle **1,** represents a complex environment for electrical wiring. It requires numerous electrical system components distributed over long distances. For example, individual battery modules and thermal management components like pumps and heaters may be located along the chassis, while control units and displays are located within the driver's cab. A conventional wiring harness for such a system would be long, heavy, and difficult to install or service.

The disclosed modular harness system **100** is particularly advantageous in this context. It provides a scalable and flexible solution for connecting these disparate components, even those located in different subsections of the large vehicle **1.** The modular harness system **100** allows for easier installation and maintenance. It can also be readily adapted to different configurations of the vehicle **1.** For instance, the modular harness system **100** can accommodate different chassis lengths, cab designs, or trailer types without requiring a complete redesign of the entire wiring architecture.

While **FIG. 1** shows a truck, the disclosed system is not limited to this specific application. The modular harness system **100** may also be applied to other heavy-duty vehicles. Examples include buses, construction equipment, or agricultural machinery. Furthermore, the principles of the disclosure can be applied to other fields, such as marine vessels, industrial automation, or stationary power systems, where robust and scalable wiring is important.

**FIG. 2** shows a schematic diagram of an exemplary modular harness system **100.** The system **100** is designed to connect a master electronic control module **10** to a plurality of electrical system components **12.** This connection is initiated via a main backbone section **5.**

The master electronic control module **10** acts as the master node or central brain of the modular harness system **100,** determining and communicating the states and managing functions like thermal management. The main backbone section **5** may connect to the master electronic control module **10** via different connector types, such as TE 1-2344950-1 or TE 2-2344950-1.

The main backbone section **5** may connect to a variety of other components, such as electronic control units, ECUs, external stops, high-voltage interlock loops, HVILs, airbag pressure control units, subnets, fan power units, original equipment manufacturer, OEM, interfaces, DC/DC temperature units, coolant level controllers, LIN outputs, fans, termination nodes, etc.

The modular harness system **100** comprises an electrical and communication interface **50,** which is connected to the modular harness system 5. The electrical and communication interface **50** operates like an adapter, serving as the origination point for the main harness wiring.

In some examples, the interface **50** may be configured to ensure regulatory compliance for the harness system **100.** For this purpose, the interface **50** may integrate various protective and communicative units. These components can include, for example, an overcurrent fuse, a signal line filter such as an EMC line filter, a galvanic isolator for DC supply, or a surge protection suppressor. The inclusion of such components within the interface **50** can enhance the safety, reliability, and regulatory adherence of the entire modular harness system **100.**

The core of the modular harness system **100** is its topology, which is based on a sequential physical interconnection of the modular harness sections **20.** As shown in **FIG. 2****,** these sections are numbered individually as **20-1, 20-2, 20-3, 20-4,** up to a final section **20-n.** Each modular harness section **20** connects to a respective electrical system component **12,** which are likewise numbered **12-1, 12-2,** and so on.

The modular harness sections **20** are interconnected in a physical series by a plurality of connector sections **40** and extension sections **30.** As shown in **FIG. 2****,** the first modular harness section **20-1** is connected to the interface **50.** Subsequently, the second modular harness section **20-2** is connected to the preceding section **20-1** via an extension section **30-1.** This physical serial chain continues, with section **20-3** connecting to section **20-2** via extension section **30-2,** and so forth, up to the final harness section **20-n.**

While the harness sections **20** are always connected in a physical series, each section is internally configured to determine if an individual signal should be connected in an electrical series or an electrical parallel. For instance, a signal for a high-voltage interlock loop (HVIL) may be routed in an electrical series, passing from an input, through the connected electrical system component **12,** and then to an output. In contrast, signals for a CAN bus may be routed in an electrical parallel, where the main bus wires pass directly from the input to the output while a short breakout connection taps into them for the component **12.** This inherent configurability of each modular harness section **20** allows the single physical chain to support multiple, distinct electrical requirements simultaneously.

Each connector section **40-1, 40-2, 40-3** is adapted to receive a corresponding extension wire **32** and to relay data and/or supply electrical power from one harness section to the next. For example, connector section **40-1** receives power and data from section **20-1** and relays it to section **20-3** via section **20-2.** This serial relay architecture can ensure efficient data transmission and power distribution throughout the entire length of the modular harness system **100.**

This modular, serial design facilitates easy installation, maintenance, and system expansion. Harness sections **20** can be added or removed from the chain as needed, reducing downtime and associated costs compared to traditional monolithic harness systems. This architecture provides a robust, flexible, and scalable solution for connecting various electrical system components to the master electronic control module **10.**

In some examples, the modular harness section **20** may be a signal harness for a battery management unit, BMU. Such a BMU signal harness may include a BMU signal socket as an interface that connects directly to its electrical system component **12,** in this case being the BMU. The BMU signal socket may include a plurality of pins, such as pins for power supply, ground, enable, ID, ID ground, HVIL in, HVIL out, CAN Lo, CAN Hi, etc. This pinout demonstrates how the physical serial connection can support different electrical circuit types simultaneously. For instance, pins for power supply and ground for each modular harness section tap into continuous power and ground lines that run through the entire serial chain, forming an electrically parallel connection. In contrast, the separate HVIL in and HVIL out pins are used to create an electrically serial circuit, where the high-voltage interlock loop signal must pass sequentially through each connected section, such as from section **20-1** to section **20-2,** to ensure the integrity of the entire chain.

In some examples, the modular harness section **20** may be a signal harness for an electrical coolant heater (ECH), serving as the electrical system component **12.** Such an ECH signal harness includes a dedicated connector to interface directly with the ECH component **12.** Like the BMU signal harness, the ECH signal harness also comprises separate subnet in/out connectors, representing the connector section **40.** These connectors allow the ECH harness to be inserted into the serial chain, receiving power and data signals from a preceding section via the subnet in connector and relaying them onward to a subsequent section via the subnet out connector. This physical pass-through structure is a practical implementation of the serial connection topology of the modular harness system **100.**

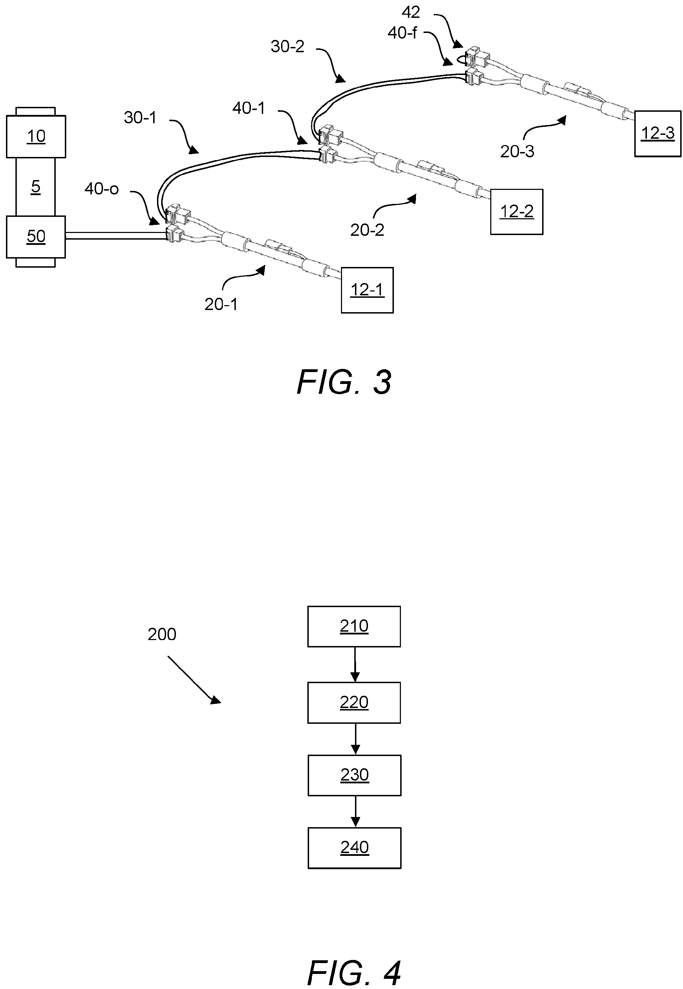

**FIG. 3** presents a perspective view of an exemplary modular harness system **100,** illustrating the arrangement and function of the connector sections **40** that enable its unique serial architecture. The system is shown originating from a master electronic control module **10** and interface **50** via a main backbone section **5,** and connecting a series of electrical system components **12-1, 12-2,** and **12-3.**

The fundamental architecture of the modular harness system **100** is a serial connection, which works by relaying power and data sequentially from one node to the next. This is physically realized by the arrangement of the connector sections **40.** As shown, the first modular harness section **20-1** connects to the interface **50.** At the end of this first section, an origin connector section **40-o** facilitates the link to the first extension section **30-1.** This extension section **30-1** then plugs into the next connector section **40-1,** which marks the beginning of the second modular harness section **20-2.** This arrangement ensures that all power and data destined for section **20-2** and any subsequent sections must first pass through section **20-1.**

This serial topology is fundamentally different from a parallel connection. In a parallel system, each modular harness section **20** would have its own independent connection branching out from a common main backbone section **5.** In such a parallel case, the main backbone **5** would run alongside all the modules, and each module would tap into it directly. In contrast, the architecture in **FIG. 3** does not use a continuous main backbone for connection points. Instead, the harness itself is extended sequentially. The second modular harness section **20-2** does not connect back to the interface **50** or the main backbone section **5;** it connects exclusively to the end of the preceding section **20-1.** This sequential, end-to-end connection is the defining characteristic of the modular harness system **100.**

This serial connection can be realized through several specific structural variants. For example, in some examples, each modular harness section **20** comprises an input connector and an output connector, and wherein the output connector of the preceding modular harness section **20-1** is connected to the input connector of the subsequent modular harness section **20-2** via the extension wire **32.** This input/output structure provides a directional, relayed flow of power and data.

In other examples, this serial connection is a daisy-chain connection, where the modules are linked together one after another in a chain-like fashion. This approach allows for simple and predictable system expansion by adding more sections to the end of the chain.

The chain-like structure continues with the second extension section **30-2** connecting the end of harness section **20-2** to the start of harness section **20-3.** In some examples, the system may further comprise a terminating plug **42** configured to be connected to a final connector section **40-f** in the series, the terminating plug **42** comprising one or more of a terminating resistor and a HVIL. As shown in **FIG. 3****,** this terminating plug **42** is connected at the very end of the last section **20-3.** This component is used for the proper functioning of the communication bus by preventing signal reflections, and for ensuring the safety of high-voltage circuits. Such a termination is a direct consequence of the serial, end-to-end architecture and is a feature not found in typical parallel-branched systems.

Thanks to this serial connection, a main communication bus of the modular harness system **100** may be formed. The length of the main communication bus is controllable based on a predetermined length. Hence, the series of interconnected modular harness sections **20** itself constitutes the main communication bus for the system **100.** This is a departure from conventional systems where a separate, continuous main backbone serves as the bus from which parallel branches are tapped. In this disclosed architecture, the bus is built sequentially, extending with each added section.

The length of this main communication bus is therefore controllable. By selectively adding or removing modular harness sections **20** and corresponding extension sections **30,** the total length of the bus can be precisely tailored to the specific needs of an application. This allows for a scalable design, adaptable for use in a compact machine or across the entire length of a heavy-duty vehicle **1** as shown in **FIG. 1****.** This architectural feature provides a technical advantage for high-speed communication protocols, such as CAN bus. In conventional parallel systems, long branches or "stubs" from a central bus create signal integrity issues due to signal reflection, which limits the functional length of these stubs to typically less than two meters. The disclosed serial architecture overcomes this limitation. While the main communication bus itself may be very long, the breakout connection to the respective electrical system component **12** is achieved via a short, internal parallel connection made within each modular harness section **20.** This internal parallel tap, which is applicable not only to CAN signals but to other data bus communications as well, remains inherently short and controlled, thus preserving signal integrity. The system **100** can thus achieve both modular scalability and robust, high-speed data communication.

In some examples, the electrical and communication interface **50** is configured to automatically adjust a parameter of the modular harness system **100.** This configuration allows the interface **50** to function as an active, intelligent node within the modular harness system **100.** It can monitor the operational state of the harness and, in response to changing conditions or requirements, dynamically alter its behavior to maintain performance or compliance.

The parameter may comprise at least one of a power distribution setting, a communication protocol setting, and a sensor calibration value. This provides specific means by which the interface **50** can exercise control. Adjusting a power distribution setting could involve modifying voltage levels or current limits to protect sensitive components. Modifying a communication protocol setting could involve changing bit rates or message IDs to ensure compatibility with various connected devices. Adjusting a sensor calibration value ensures that data from connected sensors remains accurate over time.

In some examples, the electrical and communication interface **50** is configured to receive firmware updates to address new or revised regulatory requirements. This capability means that the logic and operational rules of the interface **50** can be modified in the field without requiring hardware replacement. As industry standards for safety or emissions evolve, the modular harness system **100** can be updated via a diagnostic port or wirelessly to remain compliant.

In some examples, the electrical and communication interface **50** comprises an integrated microcontroller. This microcontroller serves as the processing core of the interface **50,** executing the software that enables its intelligent functions. It is responsible for monitoring system parameters, making decisions based on pre-programmed logic or received updates, and controlling the hardware to perform automatic adjustments.

In some examples, each connector section **40** comprises a locking mechanism to secure the modular harness sections **20** in the serial connection. This physical feature ensures that the connection between sections is robust and resistant to disconnection from vibration, shock, or physical stress, which is common in automotive or industrial environments. The locking mechanism could be a positive latch, a clip, or a threaded collar that provides a secure mechanical coupling.

In some examples, the main backbone section **5** comprises a protective casing. This casing provides physical protection for the critical wiring that connects the master electronic control module **10** to the electrical and communication interface **50.** The casing may be a rigid conduit or a flexible sheath designed to shield the wires from abrasion, impact, moisture, and other environmental hazards.

In some examples, at least one connector section **40** includes an indicator light to signal a connection status. This feature provides immediate visual feedback to an installer or technician regarding the state of the connection. The light, for example an LED, could illuminate to confirm a successful physical and electrical link, change color to indicate a fault, or blink to show active data transmission.

The modular harness system **100** is preferably configured to meet exemplary immunity requirements for signal and control ports based on established industry standards, such as IEC 61000-4-6. Certain stringent requirements are applicable to ports connected to cables whose total length may exceed three meters. This length-dependent requirement is relevant to the modular harness system **100** shown in **FIG. 3****.** The system is inherently designed for scalability over long distances through the use of one or more extension sections **30-1, 30-2.** Therefore, in many practical applications, the total cable length from the interface 50 to a distant electrical system component, such as **12-3,** will exceed this three-meter threshold, triggering the need to comply with these advanced immunity standards.

In line with this disclosure, an efficient solution for meeting such requirements is discussed. Instead of requiring each individual modular harness section **20** to be independently designed to meet these standards, the necessary protective components can be integrated into the electrical and communication interface **50** at the beginning of the serial chain. For example, to meet the radio-frequency immunity requirements, a signal line filter could be incorporated into the interface **50.** To meet the surge requirements, a surge suppressor could be included. This centralized approach to compliance simplifies the design of the individual modular harness sections **20** and provides a flexible, cost-effective way to ensure the entire system **100** adheres to necessary regulatory standards, regardless of its final configured length.

**FIG. 4** is an exemplary method **200** for arranging a modular harness system **100.** At **210,** the method **200** comprises connecting a master electronic control module to a main backbone section **5.** At **220,** the method **200** comprises connecting an electrical and communication interface **50** to the main backbone section **5.** At **230,** the method **200** comprises connecting a plurality of electrical system components **12** to a respective modular harness section **20.** At **240,** the method **200** comprises interconnecting, via a connector section **40** and an extension wire **32,** a preceding modular harness section **20-1** in series with a subsequent modular harness section **20-2,** from among the plurality of modular harness sections **20,** to relay data and/or supply electrical power.

In further examples of the disclosure the following numbered examples may be envisaged:
Example 1: A modular harness system (100) connecting to a master electronic control module (10) via a main backbone section (5), the harness system (100) comprising: a plurality of modular harness sections (20), each harness section (20) connecting to a respective electrical system component (12); an extension section (30) comprising an extension wire (32); a connector section (40) interconnecting a first harness section (20-1) with a second harness section (20-2) via said extension section (30), wherein the connector section () is adapted to: receive the extension wire (32), and relay data and/or supply electrical power from the first harness section (20-1) to the second harness section (20-2) via the received extension wire (32); and an adapter (50) connected to the harness system (100) and configured to cause regulatory compliance for the harness system (100) against at least one compliance requirement (50).
Example 2: The modular harness system (100) of example 1, wherein the connector section (40) comprises a daisy-chain connection.
Example 3: The modular harness system (100) of any preceding example, wherein the extension wire (32) comprises a shielding layer to reduce electromagnetic interference.
Example 4: The modular harness system (100) of any preceding example, wherein each modular harness section (20) includes a diagnostic interface for monitoring the status of the respective electrical system component (12).
Example 5: The modular harness system (100) of any preceding example, wherein the connector section (40) comprises a locking mechanism to securely connect the first harness section (20-1) and the second harness section (20-2).
Example 6: The modular harness system (100) of any preceding example, wherein the adapter (50) is configured to automatically adjust the harness system (100) to comply with different regulatory compliance requirements (50), optionally being an (at least near) real-time adjustment.
Example 7: The modular harness system (100) of example 6, wherein the adapter (50) adjusts the harness system (100) by dynamically modifying the power distribution to ensure compliance with electrical safety standards.
Example 8: The modular harness system (100) of any of examples 6-7, wherein the adapter (50) includes a database of regulatory compliance requirements (50) and adjusts the system parameters based on data stored in said database to meet the specific standards.
Example 9: The modular harness system (100) of any of examples 6-8, wherein the adapter (50) monitors the environmental conditions of the harness system (100) and adjusts the system to maintain compliance with temperature and humidity regulations.
Example 10: The modular harness system (100) of any of examples 6-9, wherein the adapter (50) utilizes signal filtering techniques to reduce electromagnetic interference (EMI) and ensure compliance with electromagnetic compatibility (EMC) standards.
Example 11: The modular harness system (100) of any of examples 6-10, wherein the adapter (50) performs periodic self-diagnostics and adjusts the harness system (100) to correct any deviations from compliance requirements (50).
Example 12: The modular harness system (100) of any of examples 6-11, wherein the adapter (50) adjusts the harness system (100) by calibrating connected sensors and devices to ensure accurate data transmission and compliance with measurement standards.
Example 13: The modular harness system (100) of any of examples 6-12, the adapter (50) including a feedback loop to monitor compliance status and make adjustments to the harness system (100), optionally being a continuous monitoring.
Example 14: The modular harness system (100) of any of examples 6-13, wherein the adapter (50) adjusts the harness system (100) by reconfiguring communication protocols, such as CAN or LIN bus settings, to meet data integrity and communication standards.
Example 15: The modular harness system (100) of any of examples 6-14, wherein the adapter (50) incorporates surge protection measures to adjust and maintain compliance with voltage surge regulations.
Example 16: The modular harness system (100) of any of examples 6-15, wherein the adapter (50) adjusts the harness system (100) by optimizing the routing and connection of wires to ensure compliance with layout and installation standards.
Example 17: The modular harness system (100) of any of examples 6-16, wherein the adapter (50) is configured to receive firmware updates that include new or revised regulatory compliance requirements (50) and adjust the harness system (100) accordingly.
Example 18: The modular harness system (100) of any of examples 6-17, wherein the adapter (50) adjusts the harness system (100) by managing the load balancing across multiple harness sections (20) to prevent overloading and ensure compliance with power distribution standards.
Example 19: The modular harness system (100) of any of examples 6-18, wherein the adapter (50) adjusts the harness system (100) by isolating faulty sections and rerouting power and data flow to maintain overall system compliance.
Example 20: The modular harness system (100) of any of examples 6-19, wherein the adapter (50) includes machine learning algorithms that predict potential compliance issues and proactively adjust the harness system (100) to prevent non-compliance.
Example 21: The modular harness system (100) of any preceding example, wherein each modular harness section (20) is color-coded to indicate the type of electrical system component (12) it connects to.
Example 22: The modular harness system (100) of any preceding example, wherein the adapter (50) comprises a memory unit storing compliance parameters for the regulatory compliance requirement (50).
Example 23: The modular harness system (100) of any preceding example, wherein the main backbone section (5) includes a protective casing.
Example 24: The modular harness system (100) of any preceding example, wherein the connector section (40) includes an indicator light to signal proper connection between the first harness section (20-1) and the second harness section (20-2).
Example 25: The modular harness system (100) of any preceding example, wherein the extension wire (32) comprises a flexible material to facilitate easy routing through confined spaces.
Example 26: The modular harness system (100) of any preceding example, wherein each modular harness section (20) includes an identification tag to facilitate tracking and maintenance.
Example 27: The modular harness system (100) of any preceding example, wherein the connector section (40) is waterproof to ensure reliable operation in moist environments.
Example 28: The modular harness system (100) of any preceding example, wherein the adapter (50) is detachable to allow for easy replacement or upgrading.
Example 29: The modular harness system (100) of any preceding example, comprising a plurality of adapters (50), each adapter (50) being configured to cause regulatory compliance for the system (100) with respect to a respective compliance type.
Example 30: The modular harness system (100) of any preceding example, wherein the extension section (30) includes an integrated fuse to protect the harness system (100) from electrical overload.
Example 31: The modular harness system (100) of any preceding example, wherein the connector section (40) is configured to allow for quick-disconnect capability for rapid assembly and disassembly.
Example 32: The modular harness system (100) of any preceding example, wherein the adapter (50) includes a wireless communication module to enable remote monitoring and control of the harness system (100).
Example 33: The modular harness system (100) of any preceding example, wherein the extension section (30) and the modular harness sections (20) include strain relief features to minimize mechanical stress on the wires.
Example 34: The modular harness system (100) of any preceding example, wherein the connector section (40) includes a thermal management system to dissipate heat generated during operation.
Example 35: The modular harness system (100) of any preceding example, wherein the adapter (50) comprises an integrated microcontroller configured to monitor and adjust the harness system (100) parameters.
Example 36: The modular harness system (100) of any preceding example, wherein the adapter (50) includes a software update interface allowing for the installation of firmware updates to address new or revised compliance requirements (50).
Example 37: The modular harness system (100) of any preceding example, wherein the adapter (50) comprises a real-time clock to log compliance data timestamps for audit purposes.
Example 38: The modular harness system (100) of any preceding example, wherein the adapter (50) includes a visual display to indicate the current compliance status of the harness system (100).
Example 39: The modular harness system (100) of any preceding example, wherein the adapter (50) is configured to interface with an external diagnostic tool to provide detailed compliance reports.
Example 40: The modular harness system (100) of any preceding example, wherein the adapter (50) includes one or more sensors to monitor environmental conditions such as temperature and humidity to ensure ongoing compliance with the at least one compliance requirement (50).
Example 41: The modular harness system (100) of any preceding example, wherein the adapter (50) is configured to send alerts to the master electronic control module (10) when the harness system (100) approaches non-compliance with the at least one compliance requirement (50).
Example 42: The modular harness system (100) of any preceding example, wherein the adapter (50) comprises a secure communication protocol to protect data integrity and privacy during compliance monitoring and reporting.
Example 43: The modular harness system (100) of any preceding example, wherein the adapter (50) includes an energy-efficient mode to reduce power consumption while maintaining compliance with the at least one compliance requirement (50).
Example 44: The modular harness system (100) of any preceding example, wherein the adapter (50) is configured to store historical compliance data and provide trend analysis to predict future compliance issues.
Example 45: The modular harness system (100) of any preceding example, wherein the adapter (50) includes an automatic calibration feature to adjust the harness system (100) settings for optimal performance and compliance.
Example 46: The modular harness system (100) of any preceding example, wherein the adapter (50) is equipped with a redundant power supply to ensure continuous operation during power fluctuations or outages.
Example 47: The modular harness system (100) of any preceding example, wherein the adapter (50) comprises a modular design that allows for the addition or removal of compliance-specific modules to address different regulatory requirements (50).
Example 48: The modular harness system (100) of any preceding example, wherein the adapter (50) includes a user interface allowing operators to manually verify and adjust compliance parameters.
Example 49: The modular harness system (100) of any preceding example, wherein the adapter (50) is configured to communicate with cloud-based compliance management systems to facilitate remote monitoring and control.
Example 50: The modular harness system (100) of any preceding example, wherein the adapter (50) includes a tamper-evident seal to ensure the integrity of compliance settings and prevent unauthorized adjustments.
Example 51: The modular harness system (100) of any preceding example, wherein the adapter (50) comprises a built-in self-test functionality to periodically check and verify its own operational integrity.
Example 52: The modular harness system (100) of any preceding example, wherein the adapter (50) includes a user-configurable alert system to notify relevant personnel of compliance status changes.
Example 53: The modular harness system (100) of any preceding example, wherein the adapter (50) is designed with a modular architecture to easily integrate with various types of harness systems (100) and compliance requirements (50).
Example 54: An adapter (50) adapted to be connected to the modular harness system (100) according to any of examples 1-53 wherein the adapter (50) is configured to cause regulatory compliance for the harness system (100) against at least one compliance requirement.
Example 55: A vehicle (1) comprising the modular harness system (100) according to any of examples 1-53.
Example 56: A method (200) for arranging a modular harness system (100), comprising: connecting (210) a master electronic control module (10) to a main backbone section (5); connecting (220) a plurality of electrical system components (12) to a respective modular harness section (20); interconnecting (230) a first modular harness section (20-1) with a second harness section (20-2) from among the modular harness sections (20), the interconnection being performed via a connector section (40) and an extension section (30) comprising an extension wire (32), wherein the connector section (40) is adapted to: receive the extension wire (32), and relay data and/or supply electrical power from the first harness section (20-1) to the second harness section (20-2) via the received extension wire (32); and connecting (240) an adapter (50) to the harness system (100), the adapter (50) being configured to cause regulatory compliance for the harness system (100) against at least one compliance requirement.
Example 57: A modular harness system (100) for connecting a master electronic control module (10) to a plurality of electrical system components (12), the harness system (100) comprising: a main backbone section (5) connectable to the master electronic control module (10); an electrical and communication interface (50) connected to the main backbone section (5); a plurality of modular harness sections (20), each harness section (20) connecting to a respective electrical system component (12); an extension section (30) comprising an extension wire (32); and a connector section (40) configured to interconnect a preceding modular harness section (20-1) in series with a subsequent modular harness section (20-2), from among the plurality of modular harness sections (20), to relay data and/or supply electrical power via the extension wire (32).
Example 58: The modular harness system (100) example 57, wherein each modular harness section (20) comprises an input connector and an output connector, and wherein the output connector of the preceding modular harness section (20-1) is connected to the input connector of the subsequent modular harness section (20-2) via the extension wire (32).
Example 59: The modular harness system (100) of any of examples 57-58, wherein the serial connection is a daisy-chain connection.
Example 60: The modular harness system (100) of any of examples 57-59, further comprising a terminating plug configured to be connected to a final connector section (40-f) in the series, the terminating plug comprising one or more of a terminating resistor and a high-voltage interlock loop, HVIL.
Example 61: The modular harness system (100) of any of examples 57-60, wherein the serial interconnection of the modular harness sections (20) forms a main communication bus of the modular harness system (100), the length of the main communication bus being controllable based on a predetermined length.
Example 62: The modular harness system (100) of any of examples 57-61, wherein the electrical and communication interface (50) comprises one or more of an overcurrent fuse, a signal line filter, a galvanic isolator, a CAN/LIN bus, and a surge protection suppressor.
Example 63: The modular harness system (100) of any of examples 57-62, wherein the electrical and communication interface (50) is configured to automatically adjust a parameter of the harness system (100).
Example 64: The modular harness system (100) of example 63, wherein the parameter comprises at least one of a power distribution setting, a communication protocol setting, and a sensor calibration value.
Example 65: The modular harness system (100) of any of examples 57-64, wherein the electrical and communication interface (50) is configured to receive firmware updates to address new or revised regulatory requirements.
Example 66: The modular harness system (100) of any of examples 57-65, wherein the electrical and communication interface (50) comprises an integrated microcontroller.
Example 67: The modular harness system (100) of any of examples 57-66, wherein each connector section (40) comprises a locking mechanism to secure the modular harness sections (20) in the serial connection.
Example 68: The modular harness system (100) of any of examples 57-67, wherein the main backbone section (5) comprises a protective casing.
Example 69: The modular harness system (100) of any of examples 57-68, wherein at least one connector section (40) includes an indicator light to signal a connection status.
Example 70: A vehicle comprising the modular harness system (100) according to any of examples 57-69.
Example 71: A method (200) for arranging a modular harness system (100), comprising: connecting (210) a master electronic control module (10) to a main backbone section (5); connecting (220) an electrical and communication interface (50) to the main backbone section (5); connecting (220) a plurality of electrical system components (12) to a respective modular harness section (20); and interconnecting (230), via a connector section (40) and an extension wire (32), a preceding modular harness section (20-1) in series with a subsequent modular harness section (20-2), from among the plurality of modular harness sections (20), to relay data and/or supply electrical power.

The terminology used herein is for the purpose of describing particular aspects only and is not intended to be limiting of the disclosure. As used herein, the singular forms "a," "an," and "the" are intended to include the plural forms as well, unless the context clearly indicates otherwise. As used herein, the term "and/or" includes any and all combinations of one or more of the associated listed items. It will be further understood that the terms "comprises," "comprising," "includes," and/or "including" when used herein specify the presence of stated features, integers, actions, steps, operations, elements, and/or components, but do not preclude the presence or addition of one or more other features, integers, actions, steps, operations, elements, components, and/or groups thereof.

It will be understood that, although the terms first, second, etc., may be used herein to describe various elements, these elements should not be limited by these terms. These terms are only used to distinguish one element from another. For example, a first element could be termed a second element, and, similarly, a second element could be termed a first element without departing from the scope of the present disclosure.

Relative terms such as "below" or "above" or "upper" or "lower" or "horizontal" or "vertical" may be used herein to describe a relationship of one element to another element as illustrated in the Figures. It will be understood that these terms and those discussed above are intended to encompass different orientations of the device in addition to the orientation depicted in the Figures. It will be understood that when an element is referred to as being "connected" or "coupled" to another element, it can be directly connected or coupled to the other element, or intervening elements may be present. In contrast, when an element is referred to as being "directly connected" or "directly coupled" to another element, there are no intervening elements present.

Unless otherwise defined, all terms (including technical and scientific terms) used herein have the same meaning as commonly understood by one of ordinary skill in the art to which this disclosure belongs. It will be further understood that terms used herein should be interpreted as having a meaning consistent with their meaning in the context of this specification and the relevant art and will not be interpreted in an idealized or overly formal sense unless expressly so defined herein.

It is to be understood that the present disclosure is not limited to the aspects described above and illustrated in the drawings; rather, the skilled person will recognize that many changes and modifications may be made within the scope of the present disclosure and appended claims. In the drawings and specification, there have been disclosed aspects for purposes of illustration only and not for purposes of limitation, the scope of the disclosure being set forth in the following claims.

## Claims

1. A modular harness system (100) for connecting a master electronic control module (10) to a plurality of electrical system components (12), the harness system (100) comprising:
a main backbone section (5) connectable to the master electronic control module (10);
an electrical and communication interface (50) connected to the main backbone section (5);
a plurality of modular harness sections (20), each harness section (20) connecting to a respective electrical system component (12);
an extension section (30) comprising an extension wire (32); and
a connector section (40) configured to interconnect a preceding modular harness section (20-1) in series with a subsequent modular harness section (20-2), from among the plurality of modular harness sections (20), to relay data and/or supply electrical power via the extension wire (32).

2. The modular harness system (100) of claim 1, wherein each modular harness section (20) comprises an input connector and an output connector, and wherein the output connector of the preceding modular harness section (20-1) is connected to the input connector of the subsequent modular harness section (20-2) via the extension wire (32).

3. The modular harness system (100) of any of claims 1-2, wherein the serial connection is a daisy-chain connection.

4. The modular harness system (100) of any of claims 1-3, further comprising a terminating plug (42) configured to be connected to a final connector section (40-f) in the series, the terminating plug (42) comprising one or more of a terminating resistor and a high-voltage interlock loop, HVIL.

5. The modular harness system (100) of any of claims 1-4, wherein the serial interconnection of the modular harness sections (20) forms a main communication bus of the modular harness system (100), the length of the main communication bus being controllable based on a predetermined length.

6. The modular harness system (100) of any of claims 1-5, wherein the electrical and communication interface (50) comprises one or more of an overcurrent fuse, a signal line filter, a galvanic isolator, a CAN/LIN bus, and a surge protection suppressor.

7. The modular harness system (100) of any of claims 1-6, wherein the electrical and communication interface (50) is configured to automatically adjust a parameter of the harness system (100).

8. The modular harness system (100) of claim 7, wherein the parameter comprises at least one of a power distribution setting, a communication protocol setting, and a sensor calibration value.

9. The modular harness system (100) of any of claims 1-8, wherein the electrical and communication interface (50) is configured to receive firmware updates to address new or revised regulatory requirements.

10. The modular harness system (100) of any of claims 1-9, wherein the electrical and communication interface (50) comprises an integrated microcontroller.

11. The modular harness system (100) of any of claims 1-10, wherein each connector section (40) comprises a locking mechanism to secure the modular harness sections (20) in the serial connection.

12. The modular harness system (100) of any of claims 1-11, wherein the main backbone section (5) comprises a protective casing.

13. The modular harness system (100) of any of claims 1-12, wherein at least one connector section (40) includes an indicator light to signal a connection status.

14. A vehicle (1) comprising the modular harness system (100) of any of claims 1-13.

15. A method (200) for arranging a modular harness system (100), comprising:
connecting (210) a master electronic control module (10) to a main backbone section (5);
connecting (220) an electrical and communication interface (50) to the main backbone section (5);
connecting (230) a plurality of electrical system components (12) to a respective modular harness section (20); and
interconnecting (240), via a connector section (40) and an extension wire (32), a preceding modular harness section (20-1) in series with a subsequent modular harness section (20-2), from among the plurality of modular harness sections (20), to relay data and/or supply electrical power.
